# EUROPEAN PATENT APPLICATION

(11) **EP 1 916 098 A1**
(43) Date of publication of application: **30.04.2008**
(21) Application number: 06714450.1
(22) Date of filing: 23.02.2006
(51) Int. Cl.: B32B 15/088, H05K 3/00

(54) **LAMINATE AND PROCESS FOR PRODUCING THE SAME**

(30) Priority: 19.08.2005 JP 2005238639
(71) Applicant: Asahi Kasei Kabushiki Kaisha, Osaka-shi Osaka 530-8205 (JP)
(72) Inventor: MARUYAMA, Mutsuhiro, Tokyo 100-8440 (JP); KASHIWAGI, Toshinori, Tokyo 100-8440 (JP)
(74) Representative: Weber, Thomas
(86) International application number: PCT/JP2006/303310
(87) International publication number: WO 2007/020726

(57) **Abstract**

A laminate comprising: an insulated substrate, an insulating resin layer having an imide bond and/or amide bond superimposed on the insulated substrate, and a metal thin film layer involving a structure having metal particles fusion bonded to each other, superimposed on the insulating resin layer, wherein the insulating resin layer sticks fast to the metal thin film layer in such a fashion that some of the fusion bonded metal particles are buried in the insulating resin layer, and wherein a metal oxide is present at a contact interface of the insulating resin layer with the metal thin film layer.

## Description

### TECHNICAL FIELD

The present invention relates to a metal laminate which is suitably used in an electrical wiring circuit board such as a flexible printed circuit board, and a process for producing the same.

### BACKGROUND ART

Conventionally, there are several known methods for forming a metal thin film on a substrate, such as a plating method, a vacuum vapor-deposition method, a sputtering method, a CVD method and a metallic paste method.
The plating method can relatively easily form a metal thin film on a base material having electroconductivity, but has a problem that the process becomes complicated when forming the metal thin film on an insulation base material, because an electroconductive layer needs to be firstly formed on the substrate. The plating method also has a problem that the method takes a great labor and cost in waste water treatment because of utilizing a reaction in a solution and consequently producing a large quantity of waste water, and that an obtained metal thin film has no sufficient adhesiveness to the substrate.

A vacuum vapor-deposition method, a sputtering method and a CVD method need an expensive vacuum apparatus respectively, and any of the methods has a problem of forming the film at low speed. These vapor phase methods which pile up metal in an atomic state into a film form have a problem that the metal does not adhere to the surface disturbed by slight irregularity or stain on the surface, and consequently a so-called pinhole tends to be easily formed.

In addition, in the vapor phase methods, a substrate surface is usually subjected to surface treatment such as plasma treatment before the metal thin film is formed thereon, and there is a case where the substrate receives damage in the surface treatment process. For instance, Patent Document 1 discloses that when a polyimide film is treated in plasma, an imide ring on a surface layer opens to form an oxygen functional group or a nitrogen functional group according to a condition of an oxygen concentration. The Patent Document 1 describes that a laminate produced by the steps of treating a substrate in plasma under conditions of an oxygen concentration of (1-10) × 10⁻⁶ Pa and then depositing copper on the substrate shows an initial adhesive strength of approximately 1 kgf/cm because the nitrogen functional group and copper mutually react, and shows a higher adhesive strength of 1.2 to 1.8 kgf/cm when the laminate has been heated at 150°C for 24 to 168 h because the adhesive strength is enhanced by a mutual action with a copper oxide, but there is a concern that the existence of the nitrogen functional group which has been formed by the denaturation of a polyimide group results in the degradation of the heat resistance or increase of the hygroscopicity of the polyimide film or the like, and deteriorates the physical properties of the film.

Furthermore, the laminate which is obtained by the vapor phase method such as the vacuum vapor deposition method of the Document 1 has a considerable number of pinholes produced therein as described above, and accordingly causes a problem of disconnecting electric wiring or degrading the electric reliability of electric wiring due to the pinholes piled up on the electric wiring, in the field of application in which the metallic film is converted into wires through a photolithographic technique.

A metallic paste method is a method of obtaining a metal thin film by the steps of applying a solution having a metal filler dispersed therein on an insulation substrate and heat-treating the substrate. The method has advantages of needing no special apparatus such as a vacuum apparatus, needing only a simple process, and further being capable of inhibiting the production of a pinhole such as a vapor phase method. However, a high temperature of 1,000°C or higher is usually necessary for melting the metal filler. Accordingly, the method has disadvantages that the base material is limited to a base material having heat resistance, such as a ceramic base material, and that the base material is damaged by heat or is easily damaged by a residual stress produced during being heated. The method has a further disadvantage that the obtained metal thin film has not sufficient adhesiveness to the substrate.

Patent Document 2 describes a method of improving the fastness of a metallic film to a substrate by applying a mixture including a metallic powder and a reactive organic medium on a coating layer of a soluble polyimide or the like which is a diffusion barrier and a bonding barrier, and heating the coated layer. The document describes that when forming a copper film on the substrate from a mixture including, for instance, a copper powder and a copper-containing reactive organic medium, the coated film is preferably heated in a protective atmosphere (nitrogen atmosphere containing oxygen of lower than 3 ppm by concentration or a reducing atmosphere containing hydrogen) so as to prevent copper from being oxidized, and that thus obtained copper film acquires such a level of fastness as to pass a tape test. However, the adhesive strength of the copper film is approximately 1 kgf/cm, which is not sufficient. The above method also has a problem that thus formed laminate has a roughness interface between the metallic film and the substrate because of using a metallic powder of 2 to 10 µm, and that it is difficult to form fine wiring from the metallic film in the field of application in which the metallic film is converted into wires through a photolithographic technique.

On the other hand, it is a well known technology to lower a burning temperature of a metallic paste by decreasing a particle size of the metal filler. For instance, Patent Document 3 discloses a method of directly forming a metal thin film on an insulation substrate by using a dispersion containing a metallic microparticle with a particle size of 100 nm or less dispersed therein. However, the metal thin film prepared with the method has not sufficient adhesiveness to the insulation substrate. The method further has a problem of a high cost for the metal filler, because a metal particle with a particle size of 100 nm or less used here is manufactured by the step of rapidly cooling a metallic vapor which has been volatilized in a low pressure atmosphere, and accordingly is hardly manufactured in quantity.

Another method is also well known which directly forms a metal thin film on the insulation substrate by using a paste of a metal oxide, which has a metal oxide filler dispersed therein. Patent Document 4 discloses a method of obtaining a metal thin film by the steps of applying the paste of the metal oxide which contains a crystalline polymer and has the metal oxide with a particle size of 300 nm or less dispersed therein, to the substrate, and heating the paste to decompose the crystalline polymer. However, the method needs to previously disperse the metal oxide with the particle size of 300 nm or less in the crystalline polymer, which requires much labor, and besides, needs a high temperature of 400 to 900°C for decomposing the crystalline polymer. Accordingly, the method has a problem that a usable base material requires higher heat resistance than that to the temperature, and that the kind of the base material is limited. In addition, the obtained metal thin film has not sufficient adhesiveness to the substrate.

In order to solve the problems, the present applicant has already disclosed a method for producing a metal thin film by the steps of applying a dispersion having a filler of an inexpensive metal oxide on a base material, and heating the coated film at a comparatively low temperature (Patent Document 5). According to the technology, it is possible to easily form a thin film of a metal such as copper having high adhesiveness to a substrate on the substrate, and also to form a copper film on a polyimide film or the like and use the obtained metal thin film as a substrate material of a flexible circuit. However, the metal thin film is required to further improve its adhesiveness to the substrate.

Patent Document 1: JP-A-2005-54259
Patent Document 2: JP-A-2003-506882
Patent Document 3: Japanese Patent No. 2561537
Patent Document 4: JP-A-5-98195
Patent Document 5: WO 03/051562 pamphlet

### DISCLOSURE OF THE INVENTION

### Problem to be Solved by the Invention

An object of the present invention is to provide a laminate that has a metal thin film which has particularly high adhesiveness to a substrate, has a nearly equal electroconductivity to a conventional metal thin film, contains few pinholes, and has such superior characteristics as easily making fine wiring formed therein and moisture resistance, and to provide a process for producing the same.
Another object of the present invention is to provide a simple and easy method for forming a metal thin film having a high adhesiveness on the substrate, without needing to modify properties of the substrate through plasma treatment or the like and to treat the substrate at a high temperature.

### Means for Solving the Problem

The present inventors made an extensive investigation for solving the above described problems, and as a result, have accomplished the present invention.
Specifically, the present invention comprises the following aspects.
[1] A laminate comprising: an insulation substrate, an insulative resin layer having an imide bond and/or an amide bond formed on the insulation substrate, and a metal thin film layer which is formed on the insulative resin layer and contains a structure in which metal particles are fusion-bonded to each other, wherein the metal thin film layer adheres to the insulative resin layer in such a state as some of the fusion-bonded metal particles are embedded in the insulative resin layer, and a metal oxide exists in a contacting interface between the metal thin film layer and the insulative resin layer.
[2] The laminate according to aspect [1], wherein the metal particle has a primary particle size of 200 nm or less.
[3] The laminate according to any one of aspects [1] and [2], wherein some of the metal particles are embedded in the insulative resin layer to a maximum depth of 100 nm or less at the contacting interface between the insulative resin layer and the metal thin film layer.
[4] The laminate according to any one of aspects [1] to [3], wherein the metal thin film layer has a surface roughness Ra in a range of 5 to 100 nm, in the contacting interface between the insulative resin layer and the metal thin film layer.
[5] The laminate according to any one of aspects [1] to [4], further comprising a metal-plated layer on the metal thin film layer.
[6] The laminate according to any one of aspects [1] to [5], wherein the insulative resin layer contains an insulative resin having a non-thermoplastic imide bond.

[7] The laminate according to any one of aspects [1] to [5], wherein the insulative resin layer contains an insulative resin having a thermoplastic imide bond.
[8] The laminate according to aspect [7], wherein the insulative resin layer contains a thermoplastic polyimide resin.
[9] The laminate according to any one of aspects [1] to [8], wherein the metal thin film layer contains copper, and the metal oxide existing in the contacting interface is cuprous oxide.
[10] A process for producing the laminate according to any one of aspects [1] to [4] comprising the steps of: (1) forming an insulative resin layer having an imide bond and/or an amide bond, of which the modulus of elasticity changes by heat treatment, and/or a precursor layer of the insulative resin, on an insulation substrate; and (2) applying a dispersion containing particles of a precursor of a metal thin film, which are fusion-bonded to each other by heat treatment, on the insulative resin layer and/or the precursor layer of the insulative resin, and heat-treating the dispersion in an atmosphere containing an oxidizing agent to form the metal thin film having a metal oxide in an interface between the metal thin film and the insulative resin layer.
[11] A process for producing the laminate according to any one of aspects [6] and [7] comprising the steps of: (1) applying a solution of a precursor of a polyimide resin on an insulation substrate, and then heat-treating the precursor to remove a solvent, subject the precursor to a dehydration condensation reaction and convert one part of the precursor into a polyimide resin; and (2) applying a dispersion containing particles of a precursor of a metal thin film, which are fusion-bonded to each other by heat treatment, on a layer formed in the step (1), and heat-treating the dispersion in an atmosphere containing an oxidizing agent to convert the remaining precursor into a polyimide resin and simultaneously form a metal thin film having a metal oxide in an interface between the metal thin film and the polyimide resin.
[12] The process according to aspect [11], wherein a conversion to imide bond in the step (1) is 70% or more but less than 100%.

[13] A process for producing the laminate according to aspect [8] comprising the steps of: (1) applying a solution of a thermoplastic polyimide resin on an insulation substrate, and then removing a solvent to form a layer made from the thermoplastic polyimide resin on the insulation substrate; and (2) then applying a dispersion containing particles of a precursor of a metal thin film, which are fusion-bonded to each other by heat treatment, on the layer made from the thermoplastic polyimide resin, and heat-treating the dispersion in an atmosphere containing an oxidizing agent to plasticize the thermoplastic polyimide resin and simultaneously form a metal thin film having a metal oxide in an interface between the metal thin film and the thermoplastic polyimide resin.
[14] A process for producing the laminate according to aspect [7] comprising the steps of: (1) applying a solution of a thermoplastic polyamide-imide resin on an insulation substrate, and then removing a solvent to form a layer made from the thermoplastic polyamide-imide resin on an insulation substrate; and (2) then applying a dispersion containing particles of a precursor of a metal thin film, which are fusion-bonded to each other by heat treatment, on the layer made from the thermoplastic polyamide-imide resin, and heat-treating the dispersion in an atmosphere containing an oxidizing agent to plasticize the thermoplastic polyamide-imide resin and simultaneously form the metal thin film having a metal oxide in an interface between the metal thin film and the thermoplastic polyamide-imide resin.
[15] A process for producing the laminate according to aspect [8] comprising the steps of: (1) applying a solution of a precursor of a thermoplastic polyimide resin on an insulation substrate, and then heat-treating the solution to remove a solvent, subject the precursor to a dehydration condensation reaction, convert all the precursor into polyimide and form a layer made from the thermoplastic polyimide resin on the insulation substrate; and (2) then applying a dispersion containing particles of a precursor of a metal thin film, which are fusion-bonded to each other by heat treatment, on the layer made from the thermoplastic polyimide resin, and heat-treating the dispersion in an atmosphere containing an oxidizing agent to plasticize the thermoplastic polyimide resin and simultaneously form the metal thin film having a metal oxide in an interface between the metal thin film and the thermoplastic polyimide resin.

[16] The process according to any one of aspects [13] to [15], wherein the heat treatment in step (2) is conducted at a temperature equal to or higher than a glass transition temperature of the thermoplastic polyimide resin or the thermoplastic polyamide-imide resin.
[17] The process according to any one of aspects [10] to [16], wherein the heat treatment is conducted in an inert gas atmosphere containing an oxidizing agent.
[18] The process according to aspect [17], wherein the oxidizing agent is oxygen and contained in a concentration of 30 to 500 ppm in the inert gas atmosphere.
[19] The process according to any one of aspects [10] to [18], wherein the particles of the precursor of the metal thin film are at least one selected from the group consisting of metal particles, metal oxide particles and metal hydroxide particles.
[20] The process according to any one of aspects [10] to [19], wherein the particles of the precursor of the metal thin film have a primary particle size of 200 nm or less.
[21] The process according to any one of aspects [19] and [20], wherein the particles of the precursor of the metal thin film are particles of cuprous oxide.
[22] The process according to any one of aspects [19] to [21], wherein the dispersion contains a polyhydric alcohol.
[23] The process according to any one of aspects [19] to [22], wherein the dispersion contains a straight-chain aliphatic polyether compound.

### Advantages of the Invention

A laminate according to the present invention has a metal thin film which has particularly high adhesiveness to a substrate, has a nearly equal electroconductivity to a conventional metal thin film and contains few pinholes, and has such superior characteristics as easily making fine wiring formed therein and moisture resistance. In addition, a process for producing the laminate according to the present invention can arbitrarily control a thickness of the metallic film and can easily form a metallic film of a thin film as well, so that the laminate can be preferably used for a material of a flexible circuit substrate and the like. Furthermore, the process for producing the laminate can solve the above described problems of the conventional art, which occur when forming the metal thin film on the substrate.

### BRIEF DESCRIPTION OF THE DRAWINGS

Fig. 1 is a TEM image of a cross section in the vicinity of an interface between a copper thin film and a polyimide film in Example 1;
Fig. 2 is a profile image showing the roughness of the interface, which is prepared by taking Fig. 1 with a scanner and binarizing the data; and
Fig. 3 is an analysis image showing Ra.

### BEST MODE FOR CARRYING OUT THE INVENTION

The present invention will now be described in detail below.
A laminate according to the present invention includes an insulation substrate, an insulative resin layer having an imide bond and/or an amide bond formed on the insulation substrate, and a metal thin film layer which is formed on the insulative resin layer and contains a structure in which metal particles are fusion-bonded to each other, wherein the metal thin film layer adheres to the insulative resin layer in such a state as some of the fusion-bonded metal particles are embedded in the insulative resin layer, and a metal oxide exists in a contacting interface between the metal thin film layer and the insulative resin layer.

An insulation substrate used for a laminate according to the present invention may be any of an organic material or an inorganic material, but preferably has heat resistance because the insulation substrate is heated when a metal thin film is formed thereon. A material to be preferably used includes, for instance, an inorganic material such as ceramics or glass, and a heat resistant resin such as a polyimide film.

The insulation substrate has only to have such an extent of insulation properties as a substrate which is usually used for an electrical wiring circuit board, and preferably has a surface ohmic value of 10¹³ Ωcm or more.

A thermosetting polyimide film to be particularly preferably used as the insulation substrate in the present invention includes: a film produced by condensing pyromellitic acid or a derivative of pyromellitic acid with an aromatic diamine, for instance, Kapton (registered trademark of product made by DU PONT-TORAY CO., LTD.), APICAL (registered trademark of product made by Kanegafuchi Chemical Industry Co., Ltd.) or the like; and a film produced by condensing a biphenyl tetracarboxylic acid or a derivative of a biphenyl tetracarboxylic acid with an aromatic diamine, for instance, UPILEX (registered trademark of product made by Ube Industries, Ltd.) or the like. The thickness of the polyimide film to be used is not limited, but usually can be appropriately selected from a range of about 25 to 100 µm according to the application.

The substrate may be directly used in the present invention, but may be subjected to a surface treatment such as degreasing treatment, chemical treatment with the use of an acid solution or an alkaline solution, heat treatment, plasma treatment, corona discharge treatment and sand blast treatment in order to improve an adhesiveness of the substrate to an insulative resin layer having an imide bond and/or an amide bond to be formed thereon.
In the present invention, the insulative resin layer having the imide bond and/or the amide bond is formed, on the above described insulation substrate, and a metal thin film having a structure in which metal particles are bonded to each other is stacked thereon.

An example of a resin having the imide bond and/or the amide bond to form the insulative resin layer includes a polyimide resin, a polyamide resin, a polyamide-imide resin and a polyimide ester resin. The polyimide resin is a resin having an imide bond, and is usually obtained by condensing a tetracarboxylic dianhydride component with a diamine component. The polyamide resin is a resin having an amide bond, and is obtained by condensing a dicarboxylic acid component or a halide component of a dicarboxylic acid with a diamine component. A polyamide-imide resin has both of the imide bond and the amide bond. These resins have preferably such an extent of insulation properties as a resin to be usually used for an insulation film for electrical wiring and preferably have a volume resistivity of 10¹³ Ωcm or more.

The resin having an imide bond and/or an amide bond may be a non-thermoplastic resin or a thermoplastic resin. The thermoplastic resin is a resin of which the modulus of elasticity greatly decreases when heated at a higher temperature than a glass transition temperature, and preferably has the glass transition temperature of 150°C or higher but 350°C or lower, and more preferably has the glass transition temperature of 200°C or higher but 300°C or lower.

When the laminate is required to have high heat resistance, a particularly preferable resin among resins having the imide bond and/or the amide bond is a resin having the imide bond. The resin having the imide bond may be a non-thermoplastic resin or a thermoplastic resin. Both can be used. Above all, a polyimide resin is particularly preferable, and may be a non-thermoplastic polyimide resin or a thermoplastic polyimide resin. Both can be used.

Here, a non-thermoplastic polyimide resin is a polymer having an imide ring, and means a resin which does not have a glass transition temperature, or which has the glass transition temperature, but does not decrease its modulus of elasticity greatly when heated at a higher temperature than the glass transition temperature, and consequently is not plasticized (does not cause melt flow).
Considering a heat resistance and an industrial availability of the resin, a particularly preferable resin among non-thermoplastic polyimide resins is a polyimide resin obtained by condensation-polymerizing a tetracarboxylic dianhydride and diamine or diisocyanate. An example of such a resin includes a polyimide resin prepared by using 3,3',4,4'-biphenyl tetracarboxylic dianhydride, pyromellitic dianhydride, or 3,3',4,4'-benzophenone tetracarboxylic dianhydride, as a tetracarboxylic acid component, using 4,4'-diaminodiphenyl methane, 4,4'-diaminodiphenyl ether or the like, as a diamine component, and condensation-polymerizing the components.

A thermoplastic polyimide resin is a polyimide resin having thermoplasticity, and the structure is not limited, in particular, but when used as a material for forming a circuit, has preferably low thermal expansion properties.
The thermoplastic polyimide resin greatly decreases its modulus of elasticity when heated to the glass transition temperature of the resin or a higher temperature. The glass transition temperature of the thermoplastic polyimide resin according to the present invention is preferably 150°C or higher but 350°C or lower, and more preferably is 200°C or higher and 300°C or lower.

When the glass transition temperature of the polyimide is lower than 150°C, a gap may be formed in the metallic layer on which wiring has been formed, because of a softening of the polyimide resin occurring when the laminate according to the present invention is used as a flexible printed circuit board or the like and is heated, for instance, at 150°C. When the glass transition temperature exceeds 350°C, the polyimide resin may not develop a high adhesiveness between the metal thin film and the insulation substrate.

The thermoplastic polyimide resin is preferably polymerized by using at least one tetracarboxylic acid component selected from among 3,3',4,4'-biphenyl tetracarboxylic dianhydride, pyromellitic dianhydride, bis(3,4-dicarboxyphenyl)ether dianhydride, (3,4-dicarboxyphenyl)sulfone dianhydride, (3,4-dicarboxyphenyl)hexafluoropropane dianhydride, 3,3',4,4'-benzophenone tetracarboxylic acid, 2,2-bis(3,4-dicarboxyphenyl)propane dianhydride, bis(3,4-dicarboxyphenyl)difluoromethane dianhydride or the like, and at least one diamine component selected from among [4- (3-aminophenoxy) phenyl] sulfone, bis[4-(4-aminophenoxy)phenyl]sulfone, bis[4-(4-aminophenoxy)phenyl]hexafluoropropane, 3,3'-diaminodiphenylsulfone, 3,4'-diaminodiphenylsulfone, 4,4'-diaminodiphenylsulfone, bis[4-(3-aminophenoxy)phenyl]ether, bis[4-(4-aminophenoxy)phenyl]ether, bis[4-(3-aminophenoxy)phenyl]propane, bis[4-(4-aminophenoxy)phenyl]propane, 3,3'-diaminodiphenyl propane, 3,3'-diaminobenzophenone, 4,4'-bis(3-aminophenoxy)biphenyl, 2,2-bis(4-(4-aminophenoxy)phenyl)perfluoropropane or the like.

The non-thermoplastic polyimide resin and the thermoplastic polyimide resin may be used solely or in combination with one or more other resins. Alternatively, a plurality of layers may be formed from resins which have different chemical compositions respectively.

The thickness of an insulative resin layer having an imide bond and/or an amide bond in a laminate of the present invention is preferably in a range of 0.1 to 20 µm, and more preferably of 0.1 to 10 µm.
When the layer is thinner than 0.1 µm, the layer may be hardly formed, and may not sufficiently develop an effect of improving an adhesive strength between the insulation substrate and the metal thin film layer. Even when the film thickness exceeds 20 µm, the effect of the present invention is not disturbed, but in most cases, the thick film makes a laminated substrate thicker than that of being required, and besides, is not economical.

The present invention has firstly a feature in which a laminate has a metal thin film layer having a structure in which metal particles are fusion-bonded to each other on the above described insulative resin layer, and the metal thin film layer adheres to the insulative resin layer in such a state that some of the fusion-bonded metal particles are embedded in the insulative resin.

The structure in which the metal particles are fusion-bonded to each other means a structure in which the metal particles merge these interfaces into each other and are integrated.
The metal thin film layer including the structure in which the metal particles are fusion-bonded to each other preferably has a structure in which metallic microparticles with a primary particle size of 200 nm or less are fusion-bonded to each other, because the structure imparts the film denseness and adhesiveness.

When observing the metal thin film layer having the structure in which the metallic microparticles having the primary particle size of 200 nm or less are fusion-bonded to each other, with an electron microscope, it is observed that there are coexisting two portions. One portion shows an interface between metals, and the other portion shows a continuous layer. The thickness of the metal thin film layer of the laminate according to the present invention is not limited, but normally is 0.05 to 50 µm. The type of a metal used for the metal thin film layer according to the present invention is not limited in particular, as long as the metal is formed from a precursor of the metal thin film. A metal to be preferably used is copper, silver, nickel, palladium and the like.

The above described metal thin film layer adheres to the insulative resin layer in a state that some of the fusion-bonded metal particles are embedded in the insulative resin. Specifically, the laminate shows a structure in which some of the fusion-bonded particles are embedded in the insulative resin layer as anchors in an interface between the metal thin film and the insulative resin layer, when a cross section of the laminate is observed with a transmission electron microscope (TEM). The maximum depth of some embedded metal particles in the insulative resin layer in the interface is preferably 100 nm or less, and more preferably is 50 nm or less. In addition, a surface roughness Ra in the interface between the metal thin film layer and the insulative resin layer is preferably in a range of 5 to 100 nm, and more preferably of 5 to 50 nm, which originates in the fact that some of the metal particles are embedded in the insulative resin layer. When the interface is controlled into such a range of the state, the laminate can develop a particularly high adhesive strength.

When the metal thin film layer is formed by using ultra-fine particles of a metal oxide having a primary particle size of approximately 8 nm as the particle of the precursor of the metal thin film, it is confirmed that the metal thin film layer shows a structure in which the ultra-fine particles are fusion-bonded normally to grow into the metallic microparticles with the particle sizes of approximately 10 to 50 nm and the metallic microparticles are embedded in a polyimide film up to a depth of 1 to 40 nm in the interface between the metal thin film layer and the insulative resin layer. In this case, the interface shows the Ra of approximately 10 nm.

A laminate according to the present invention has secondly a feature in which a metal oxide exists in a contacting interface between a metal thin film layer and an insulative resin layer.
The metal oxide existing in the interface has an effect of increasing an adhesive strength between the metal thin film layer and the insulative resin layer, and accordingly is preferably distributed throughout the interface uniformly. The reason why the metal oxide shows the effect of increasing the adhesive strength is not necessarily clear, but is considered to be that the metal oxide forms a preferred chemical bond with an imide group or an amide group of the insulative resin layer.

The laminate according to the present invention develops a high adhesive strength due to the presence of the metal oxide, even though the imide group or the amide group of the insulative resin layer is not modified by plasma treatment or the like. It is usually said that the plasma treatment converts the imide group or the amide group into other nitrogen-containing polar groups by the high energy of plasma, and that the converted polar groups contribute to an improvement of the adhesiveness, but there is a concern that the polar group may increase hygroscopicity and a migration speed of a metal ion. The laminate according to the present invention has a feature of having the high adhesive strength, even though the insulative resin layer is not subjected to such treatment.

A thickness of the metal oxide in the present invention is not particularly limited, but in order to enhance the adhesive strength and electroconductivity, the thickness is usually in a range of 1 to 200 nm. As long as the metal oxide does not remarkably decrease the electroconductivity of the metal thin film layer, the metal oxide may be distributed not only in the interface of the insulative resin layer but also partially in an inner layer of the metal thin film layer.

An example of the metal oxide includes a copper oxide, nickel oxide, cobalt oxide, silver oxide, ruthenium oxide, osmium oxide, manganese oxide, molybdenum oxide and chromium oxide. Among them, cuprous oxide is particularly preferably used, because of having a particularly superior effect of improving the adhesive strength. In the laminate according to the present invention, a particularly preferable combination of the metal thin film layer and the metal oxide is a case in which the metal thin film layer includes copper and the metal oxide is cuprous oxide.

A laminate having the second metal layer further plated on the above described metal thin film layer is preferable, because of further acquiring characteristics such as electrical characteristics and mechanical properties of the second metal layer in addition to those of the first metal thin film layer.
A type of the metal for a plating layer is not particularly limited, but copper, nickel and gold are preferable because of imparting high electroconductivity and high stability to the laminate. Among them, copper is preferable because of showing a low ohmic value and being industrially available. The thickness of the plated layer is not limited, but is normally 0.05 to 50 µm.

Next, a process for producing a laminate of the present invention will now be described.
A process for producing a laminate of the present invention includes the steps of: (1) forming an insulative resin layer having an imide bond and/or an amide bond, of which the modulus of elasticity changes by being heat treatment, and/or a precursor layer of the insulative resin on an insulation substrate; and (2) applying a dispersion containing particles of a precursor of a metal thin film, which are fusion-bonded to each other by heat treatment, on the insulative resin layer and/or the precursor layer of the insulative resin, and heat-treating the dispersion in an atmosphere containing an oxidizing agent to form the metal thin film having a metal oxide in an interface between the metal thin film layer and the insulative resin layer.

The insulative resin layer having an imide bond and/or an amide bond, of which the modulus of elasticity changes by heat treatment, and/or a precursor layer of the insulative resin means an insulative resin layer which shows an observable change of the modulus of elasticity at a temperature at which a dispersion of precursor particles of a metal thin film is heat-treated, and has the imide bond and/or the amide bond and/or a precursor layer of the insulative resin. The precursor layer of the insulative resin having the imide bond and/or the amide bond means a precursor layer of the insulative resin which forms the imide bond or the amide bond when heated. The insulation resin obtained after having been heat-treated may be a non-thermoplastic resin and a thermoplastic resin. Both of them can be used. For instance, a precursor of a polyimide resin includes a compound having a thermosetting functional group which forms the imide bond when heated, such as a polyamic acid and a diisocyanate adduct.

A change of the modulus of elasticity due to heat treatment means a temporary decrease of the modulus of elasticity when heat-treated, in the case where an insulative resin layer is formed from an thermoplastic resin, and means an increase of the modulus of elasticity due to cross-linking in a precursor layer having a low modulus of elasticity and an unreacted thermosetting functional group caused by heat treatment, in the case where the insulative resin layer contains the precursor layer or a precursor. The insulative resin layer which is obtained by heat-treating the layer containing the precursor layer or the precursor may be the thermoplastic resin or a non-thermoplastic resin.

Particles of a precursor of a metal thin film, which are fusion-bonded to each other when heat-treated, are particles that form a thin film formed of an apparently continuous metal layer of metal particles mutually joined when a dispersion containing the particles of the precursor has been applied into a film form and the film has been heated.

The particles of the precursor of the metal thin film have a primary particle size preferably of 200 nm or less, more preferably of 100 nm or less, and most preferably of 30 nm or less, so as to form a dense metal thin film when heat-treated. In addition, the particles of the precursor of the metal thin film have a primary particle size preferably of 1 nm or more so as to control the viscosity of the dispersion appropriately and make the dispersion easily handled.

A material for particles of a precursor of a metal thin film used in the present invention is not limited, as long as the particles form a metal thin film by heat treatment, and preferably includes metal particles, metal hydroxide particles and a metal oxide particles.
Preferable metal particles are metal microparticles which are produced by a technique such as a wet process or an in-gas evaporation technique, and have a primary particle size of 10 nm or less, and particularly preferable metal particles are copper microparticles.
An example of the metal hydroxide particles includes particles of a compound such as copper hydroxide, nickel hydroxide and cobalt hydroxide, but the metal hydroxide particles which form a copper thin film in particular is preferably the copper hydroxide particles.

The metal oxide particles are particularly preferable because of easily forming a metal thin film by heat treatment. The metal oxide particles include, for instance, a copper oxide, silver oxide, palladium oxide and nickel oxide. The copper oxide which can be converted into copper by heat treatment includes cuprous oxide, cupric oxide and copper oxides having other oxidation numbers. Any of the above oxides can be used. Particles of the cuprous oxide are particularly preferable because of easily being reduced. Above all, a metal oxide microparticles with a primary particle size of 200 nm or less are particularly preferable because of having an extremely high dispersibility to a dispersion medium.

The metal oxide microparticles may be a commercialized product or be synthesized by using a well-known synthesis method. For instance, there is a well-known method for synthesizing ultra-fine particles of the cuprous oxide having a particle size of less than 100 nm, by heating a complex of copper acetylacetonate in a polyol solvent approximately at 200°C (Angewandte Chemie International Edition, No. 40, Volume 2, p.359, in 2001).

A metal thin film is formed by the steps of: applying a dispersion containing particles of a precursor of the metal thin film on an insulative resin layer and subsequently heat-treating the dispersion. A metal thin film having a metal oxide in the interface between the metal thin film and the insulative resin layer is formed by heat-treating the metal thin film in an atmosphere containing an oxidizing agent.

The reason why a laminate produced according to the method of the present invention acquires an improved adhesive strength is not necessarily clear, but is considered to be as follows.
(1) When the particles of the precursor of the metal thin film form the metal thin film layer by heat treatment, some of the particles of the precursor of the metal thin film form the metal thin film layer while becoming embedded in the insulative resin layer and/or a precursor layer of the insulative resin, work as fine anchors, adhere to the insulative resin layer, and increase the adhesive strength of the interface.
(2) A metal oxide produced in the interface is considered to form a chemical bond with the insulative resin layer having an imide bond or an amide bond. The imide bond and the amide bond are polar groups having an O atom and an N atom, and accordingly are considered to form an adequate chemical bond with the metal oxide.

As a result of having observed the cross section of the laminate through a transmission-type electron microscope (TEM), it was observed that metal particles are fusion-bonded to each other, and some of them are embedded in the interface of the insulative resin layer to work as anchors. In addition, as a result of having analyzed the composition of the interface, it was confirmed that the metal oxide is included in the interface. Accordingly, it was considered that the fine anchors and the chemical bond enable the laminate to acquire a high adhesive strength even though having a low roughness. The laminate according to the present invention has a low roughness in between the insulative resin and the metal layer, which gives a particularly preferable effect such as a high linearity of electric wiring, when fine electric wiring is formed on the laminate of the present invention with a photolithographic technique.

Among processes for producing an insulative resin having an imide bond and/or an amide bond, of which the modulus of elasticity changes during heat-treated, and/or a precursor layer of the insulative resin, particularly, examples of producing (A) polyimide resin layer containing a precursor of the polyimide resin and (B) thermoplastic polyimide resin layer will now be described below.

(A) The polyimide resin layer containing the precursor of the polyimide resin is formed by the steps of: applying a solution of the precursor of the polyimide resin on an insulation substrate; and heating the applied solution to remove the solvent therefrom, cause a dehydration condensation reaction therein and convert one part of the precursor into the polyimide resin. Among polyimide resins, both of a non-thermoplastic polyimide resin and a thermoplastic polyimide resin can be used. The precursor of the polyimide resin is a compound in the state of being not yet completely converted into the polyimide resin by a condensation reaction, and includes, for instance, a polyamic acid and a diisocyanate adduct. The polyimide resin precursor may be used solely or in combination with one or more other resins.

The precursor of the polyimide resin is partially converted into the polyimide resin by heat treatment. The conversion ratio is not limited, but is preferably controlled into 70% or more but less than 100%. When the conversion ratio is controlled in the range, the polyimide resin layer acquires an improved adhesiveness to a metal thin film layer to be subsequently formed thereon. For instance, when a polyamic acid is employed as the precursor of the polyimide resin for forming a polyimide film, the polyimide film with an imidizing conversion ratio (R1) of about 90% is obtained by the steps of: preheating the polyamic acid at about 120°C; and causing a conversion reaction in the preheated polyamic acid at about 200°C.

The above described conversion ratio is an index that indicates a ratio of condensing groups to condensable functional groups in the polyimide resin layer, which can form the imide bond. The conversion ratio of 100% is defined as the time when all the condensable functional groups have been condensed into the imide bond. Usually, the conversion ratio can be estimated by measuring the amount of the imide bonds after the conversion treatment step with an infrared absorption instrument. Specifically, the conversion ratio can be estimated by comparing a relative intensity of the peak of the imide group absorbed by infrared rays in the vicinity of 1780 cm⁻¹ with a sample having the conversion ratio of 100%.

(B) There are two methods for forming the thermoplastic polyimide resin layer. One is a method (B-1) including the steps of: applying a solution of the thermoplastic polyimide resin onto the insulation substrate; and removing the solvent to form a layer made from the thermoplastic polyimide resin on the insulation substrate. The other is a method (B-2) including the steps of: applying a solution of a precursor of a thermoplastic polyimide resin on an insulation substrate; heating the applied solution to remove the solvent therefrom, cause a dehydration condensation reaction therein, convert all the precursor into the polyimide resin and form the layer made from the thermoplastic polyimide resin on the insulation substrate.

In the method (B-1), the solution of the thermoplastic polyimide resin coated on the insulation substrate is subjected to the step of heat treatment or the like, and the solvent is removed in the step. In the heat treatment step, it is preferable to heat the coated solution from a low temperature gradually to a high temperature. When the coated solution is rapidly heated at a high temperature, a skin layer forms on the surface of the resin, and the solvent may hardly evaporate or may cause foaming.

In the method (B-2), the solution of the precursor of the thermoplastic polyimide resin is applied on the substrate and is heated. Then, the solvent is removed, and the precursor causes a ring-closing reaction due to the dehydration condensation reaction to form the imide group. In the heat treatment step, the solvent-removing treatment and the imide cyclization treatment may be carried out at the same time, or may be carried out sequentially. In the heat treatment step, it is preferable to heat the coated solution from a low temperature gradually to a high temperature. It is also possible to employ a plurality of polyimide precursors and produce the laminate by stacking them on a substrate. In this case, in order to impart a sufficient adhesive force between the respective polyimide resin layers in the laminate, it is preferable to coat the solution of the plurality of the precursors at one time or sequentially, or to remove the solvent at a temperature of causing an imide-ring-closing reaction or a lower temperature and heat the precursors to convert them into the polyimide resin at one time.

It is a usually used technique for forming a thermoplastic polyamide-imide resin on an insulation substrate to apply a solution of a thermoplastic polyimide resin on the insulation substrate and remove the solvent to form a layer made from the thermoplastic polyimide resin on the insulation substrate.

A method of applying the solution of an insulative resin having an imide bond and/or an amide bond or a precursor of the insulative resin on the insulation substrate is not limited. The usable method includes, for instance, a dip coating method, a bar coating method, a spin coating method, a roll coating method and a spray coating method. An organic solvent is normally used as a solvent for a solution to be applied on the substrate. The organic solvent includes, for instance, N-methyl-2-pyrrolidone, N,N-dimethylacetamide, N,N-dimethylformamide, 1,3-dimethyl-2-imidazolidinone, N,N-diethylacetamide, N,N-dimethylmethoxyacetamide, dimethylsulfoxide, dimethylsulfone, hexamethylphosphoramide, tetramethylurea, N-methylcaprolactam, butyrolactam, tetrahydrofuran, m-dioxane, p-dioxane, 1,2-dimethoxyethane, bis(2-methoxyethyl)ether, 1,2-bis(2-methoxyethoxy)ethane, bis 2-(2-methoxyethoxy)ethyl ether, 1,3-dioxane, 1,4-dioxane, cyclohexanone, pyridine and picoline. These solvents may be used solely, or in combination with one or more other solvents.

The above described solution has a concentration usually of 5 to 30 wt% and preferably of 10 to 20 wt%, though depending on a polymerization degree of the insulative resin having the imide bond and/or the amide bond or the precursor of the insulative resin. When the concentration of the polymer is lower than 5 wt%, a film with a sufficient thickness may not be obtained by one time of application. When the concentration of the polymer is higher than 30 wt%, the viscosity of the solution increases and it may be difficult to apply the solution onto the substrate. In such a case, it is allowed to add various additives such as a lubricating agent, a leveling material and a defoaming agent for imparting smoothness to the surface of the coated film, as needed. In order to adjust an evaporation rate of the solvent, an aromatic-hydrocarbon-based solvent can be used in such a range as to uniformly dissolve the polymer therein. Furthermore, the solution may be added with various additives including a curing agent such as a well-known amine-based curing agent, an adhesion-imparting agent such as a silane coupling agent and an epoxy compound and a flexibility-imparting agent such as rubber; and various catalysts.

A process for producing a laminate of the present invention includes the steps of: (1) forming an insulative resin layer having an imide bond and/or an amide bond, of which the modulus of elasticity changes by being heat-treated, and/or a precursor layer of the insulative resin; and (2) then applying a dispersion containing particles of a precursor of a metal thin film, which are fusion-bonded to each other when heat-treated, on the layer, and heat-treating the coated dispersion in an atmosphere containing an oxidizing agent to form a metal thin film layer having a metal oxide in the interface between the metal thin film and the insulative resin layer.

The heat treatment serves functions of (i) forming the metal thin film layer having a structure in which the metal particles are fusion-bonded to each other, and (ii) forming the metal oxide in the interface between the metal thin film layer and the insulative resin layer. The heat treatment is performed in the atmosphere containing the oxidizing agent so as to form the metal oxide in the interface between the metal thin film and the insulative resin layer. The oxidizing agent is not limited as long as it forms the metal oxide in the interface, and includes, for instance, oxygen, ozone and water. The concentration of oxydizing agent in the atmosphere is appropriately determined while considering how easily the metal thin film layer is oxidized.

Other purposes of the heat treatment are (iii) to change the modulus of elasticity of the layer made from the insulative resin having the imide bond and/or the amide bond, and/or made from the precursor of the insulative resin, and (iv) to completely convert the unconverted precursor of the insulative resin into the imide bond and/or the amide bond when the unconverted precursor still remains. The purposes (i) to (iv) are usually accomplished at the same time, but may be achieved sequentially.

When a thermoplastic resin is used as an undercoat of the metal thin film layer, the thermoplastic resin is heat-treated preferably at a glass transition temperature or a higher temperature, more preferably at a temperature of 40 to 100°C higher than the glass transition temperature, and is usually at a temperature of 200°C or higher but 400°C or lower. For instance, when the thermoplastic polyimide resin having the glass transition temperature of 260°C is applied on the insulative resin layer, the thermoplastic polyimide resin is heat-treated preferably at 300 to 360°C, which are higher temperatures than the glass transition temperature.

When the metal thin film layer formed through heat treatment is made from an easily oxidizable metal such as copper, the coated dispersion layer is heat-treated preferably in an inert atmosphere containing the oxidizing agent, and more particularly in the inert atmosphere containing oxygen in a concentration adjusted to about 30 to 500 ppm. The inert atmosphere indicates an atmosphere of an inert gas such as argon gas and nitrogen gas. When the concentration of oxygen is lower than 30 ppm, a long period of heating time may be necessary for producing the metal oxide in the interface. On the other hand, when the concentration of oxygen exceeds 500 ppm, the metal thin film layer may lower its electroconductivity because of being excessively oxidized.

A heating temperature and a heating period of time may be appropriately determined so as to correspond to the type of the particle of the precursor of the metal thin film, in consideration of the above described (i) to (iv), but the heating temperature is normally in a range of 200 to 500°C, and the heating period of time is in a range of 1 to 120 minutes. In the case where a copper thin film having cuprous oxide in the interface is formed from a dispersion of ultra-fine particles of the cuprous oxide having a primary particle size of about 20 nm, the coated dispersion is heat-treated normally at 350°C for about 30 minutes when heat-treated in an atmosphere containing about 100 ppm by concentration of oxygen.
Heating means to be used for the heat treatment includes: a radiation heating furnace using far infrared rays, infrared-rays, microwave, an electron beam or the like; an electric furnace; and an oven.

A method of applying a dispersion of particles of a precursor of a metal thin film includes a dip coating method, a spray coating method, a spin coating method, a bar coating method, a roll coating method, an ink jet method, a contact printing method and a screen printing method. The optimal application method has only to be appropriately selected so as to match the viscosity of the dispersion. The thickness of the metal thin film to be finally obtained can be adjusted by adjusting the thickness of a film formed of the applied dispersion.

When intending to form the metal thin film into metallic wiring, a metallic circuit pattern can be formed by applying the dispersion of the particles of a precursor of the metal thin film into a circuit shape, and heat-treating the applied dispersion. For the above use, such a drop-on-demand type application device is used as an ink jet printer or a wire dispenser.

An ink jet method is a method of charging a dispersion into an ink-jet printer head, and adding a fine oscillation to a piezoelectric element or the like through an electric drive to make droplets of the dispersion discharged. On the other hand, a dispenser method is a method of charging the dispersion into a dispenser tube provided with a discharge needle on its tip, and adding an air pressure thereto to make the dispersion discharged.

The circuit pattern can be formed into an arbitrary pattern by moving the ink-jet head and a dispenser discharge needle to directions in a plane direction through an action of a robot. When employing these application methods, it is possible to form a circuit even on a substrate having steps so as to follow the steps by moving the robot in a vertical direction.

When the ink jet method is employed, a line width of a wiring pattern to be drawn can be adjusted by controlling the size of droplets of the dispersion and the pattern of landing droplets, which are discharged from the ink-jet printer head. On the other hand, when the dispenser method is employed, the line width can be adjusted by controlling the width of the dispersion which is discharged from the discharge needle, through controlling the inner and outer diameters of the discharge needle, a discharge pressure, a drawing speed and the like.

When applying the dispersion into the circuit form, the dispersion is applied so as to form lines normally with a width in a range of 1 to 400 µm. Then, the line of the obtained metal wiring acquires the width in a range of 0.5 to 300 µm. In addition, the thickness of the metallic wiring which is finally obtained can be adjusted by adjusting the thickness of the applied dispersion. The thickness of the applied dispersion is normally in a range of 0.1 to 100 µm, and then the thickness of the obtained metal wiring is in a range of 0.05 to 50 µm.

A dispersion medium used for a dispersion containing particles of a precursor of a metal thin film (hereinafter referred to merely as "dispersion") according to the present invention is not limited, as long as the medium can uniformly disperse the particles therein.
The dispersion further preferably includes a polyalcohol because the dispersion is more adequately converted into the metal thin film from the particles of the precursor of the metal thin film when heat-treated.

The polyalcohol is a compound having a plurality of hydroxyl groups in the molecule. The polyalcohol is hardly volatilized because the boiling point is moderately high, so that the dispersion using the polyalcohol is preferable because of being easily printed and easily forming the metal thin film. Among polyalcohols, a preferred polyalcohol is a polyalcohol having 10 or less carbon atoms. Among them, particularly preferred polyalcohol is ethylene glycol, diethylene glycol, 1,2-propanediol, 1,3-propanediol, 1,2-butanediol, 1,3-butanediol, 1,4-butanediol, 2,3-butanediol, pentanediol, hexanediol and octanediol, all of which have a low viscosity. These polyalcohols may be used solely or in combination with one or more other polyalcohols.

The reason why the polyalcohol improves a film-forming capability when the metal thin film is formed is not necessarily clear, but it is considered that when the particle of the precursor of the metal thin film is a metal oxide particle or a metal hydroxide particle, the polyalcohol interacts with a hydroxyl group on the particle surface to protect the particle surface and inhibits the particles from agglomerating with each other. The polyalcohol also has an effect of reducing the metal oxide particle or the metal hydroxide particle, which is preferable.

A dispersion containing a straight-chain aliphatic polyether compound shows an effect of improving a film-forming capability when a metal thin film is formed, and besides, decreases an ohmic value of the metal thin film obtained through heat treatment, which are preferable. The reason why the straight-chain aliphatic polyether compound improves the film-forming capability and decreases the ohmic value is considered to be that the straight-chain aliphatic polyether compound protects particles of a precursor of the metal thin film from locally forming grains during being heat-treated, by acting as an easily decomposable and easily diminishable binder. In addition, the ohmic value of the metal thin film tends to be particularly lowered by using the above described polyalcohol together with the straight-chain aliphatic polyether compound, which is preferable.

A preferred number average molecular weight of the straight-chain aliphatic polyether compound is 150 to 600. When the molecular weight is in the range, the dispersion shows the extremely high film-forming capability when the metal thin film is formed, and on the other hand, tends to form a metal thin film with a low volume ohmic value because the straight-chain aliphatic polyether compound is easily decomposed and vanishes. When the number average molecular weight is less than 150, the dispersion tends to lower the film-forming capability when the metal thin film is formed through a baking step. When the number average molecular weight is more than 600, the dispersion tends to increase the volume ohmic value of the obtained metal thin film.

The straight-chain aliphatic polyether compound has preferably a repeated unit of an alkylene group having 2 to 6 carbon atoms. A polyether copolymer and a polyether block copolymer, which are a binary or higher valency copolymer, may be used as well as the straight-chain aliphatic polyether compound.

The straight-chain aliphatic polyether compound specifically includes: a polyether homopolymer such as polyethylene glycol, polypropylene glycol, and polybutylene glycol; a binary copolymer such as ethylene glycol/propylene glycol, and ethylene glycol/butylene glycol; and a straight-chain ternary copolymer such as ethylene glycol/propylene glycol/ethylene glycol, propylene glycol/ethylene glycol/propylene glycol, and ethylene glycol/butylene glycol/ethylene glycol, but is not limited to these compounds. The block copolymer includes a polyether block copolymer including: a binary block copolymer such as polyethylene glycol-polypropylene glycol and polyethylene glycol-polybutylene glycol; and a straight-chain ternary block copolymer such as polyethylene glycol-polypropylene glycol-polyethylene glycol, polypropylene glycol-polyethylene glycol-polypropylene glycol, and polyethylene glycol-polybutylene glycol-polyethylene glycol.

An end structure of the straight-chain aliphatic polyether compound is not limited as long as the compound does not give any harmful influence to the dispersibility of particles or the solubility of particles into a dispersion medium, but when the polyether compound has at least one end having an alkyl group, the polyether compound improves its decomposing and vanishing properties when baked and decreases the volume ohmic value of the metal thin film to be obtained, which is preferable. When the alkyl group is excessively long, the dispersion tends to obstruct the dispersibility of particles and increase the viscosity, so that the alkyl group preferably has 1 to 4 carbon atoms. The reason why the decomposing and vanishing properties of the dispersion in a baking step are improved when the polyether compound has at least one end having the alkyl group is not necessarily clear, but is assumed to be that the alkyl group contributes to weakening of an interactive force between a particle and the polyether compound or between the polyether compound and the polyether compound, based on a hydrogen bond or the like.

The straight-chain aliphatic polyether compound particularly preferably has a structure which has the alkyl group in one end and a hydroxyl group on the other end. The compound includes, for instance, polyethylene glycol methyl ether and polypropylene glycol methyl ether.

A ratio of a particle of a precursor of a metal thin film in a dispersion is not limited, but is preferably 5 to 90 wt% and more preferably is 20 to 80 wt% with respect to the total amount of the dispersion. When a weight of the particle in the dispersion is in the above described range, the particles are well dispersed, and a metal thin film having an appropriate thickness can be obtained by one time of application and heat treatment, which are preferable.

A ratio of a particle of the polyalcohol in the dispersion is preferably 5 to 70 wt% and more preferably is 10 to 50 wt% with respect to the total amount of the dispersion.
A ratio of a particle of the straight-chain aliphatic polyether compound in the dispersion is preferably 0.1 to 70 wt% and more preferably is 1 to 50 wt% with respect to the total amount of the dispersion. When an amount of the added polyether compound is less than 0.1%, the obtained metal thin film may have low denseness or have low adhesiveness to a base material. On the other hand, when an amount of the added polyether compound exceeds 70%, the dispersion may increase its viscosity.

A preferred weight ratio of the polyether compound to the particle of the precursor of the metal thin film varies depending on a type of the used particle and the polyether compound, but is normally in a range of 0.01 to 10. When the dispersion includes the polyether compound in the above range, the dispersion improves the denseness of the obtained metal thin film and further decreases the volume ohmic value.

The above described dispersion according to the present invention may be blended with additives such as an antifoaming agent, a leveling agent, a viscosity modifier and a stabilizer, as needed. In addition, the above described dispersion may include a similar type or a different type of a metallic powder to or from a metal derived from a particle of a precursor of a metal thin film, as long as the metallic powder does not hinder the particles of the precursor of the metal thin film from forming the metal thin film through being fusion-bonded with each other and does not hinder the metal thin film from adhering to an insulative resin layer. In order that the metal thin film forms such an interfacial morphology as to show a high adhesive strength to the insulative resin layer, the metallic powder preferably has a small particle size. The size is preferably 1 µm or less, and more preferably is 200 nm or less.

A general method for dispersing a powder into a liquid can be used in a process for producing the above described dispersion. The powder has only to be dispersed, for instance, with a supersonic method, a mixing machine, a three combination roll and a ball mill after having mixed composing materials such as the particle of the precursor of the metal thin film, a dispersion medium, and a straight-chain aliphatic polyether compound. The powder can also be dispersed by combining a plurality of methods among the dispersion methods. The dispersion treatments may be carried out at room temperature, or may be carried out while the dispersion is heated so that the viscosity of the dispersion can be decreased. When a composing material other than the particle of the precursor of the metal thin film is a solid, it is preferable to add the particles while heating the composing material to a temperature at which the composing material becomes liquid and carry out the above described operation. When the dispersion is converted into a flowable solid, it is preferable to disperse the powder while adding a shear stress to the flowable solid and employ a three combination roll, the mixing machine or the like.

A laminate according to the present invention can have the second metallic layer plated on the metal thin film layer obtained through the above described method and can impart functions and characteristics to the first metal thin film layer. When a metal is plated on the metal thin film layer, the volume ohmic value of the metal thin film layer obtained from a dispersion containing particles of a precursor of a metal thin film is not limited as long as the metal can be plated thereon, but preferably is 1 × 10⁻⁴ Ωcm or less and more preferably is 1 × 10⁻⁵Ωcm or less. When the volume ohmic value is larger than 1 × 10⁻⁴ Ωcm, it is difficult to increase current density in an electrolytic plating step, and it may take a long period of time for plating the metal.

There is a dry plating method and a wet plating method as a technique for plating a metal on the metal thin film obtained from the dispersion containing particles of a precursor of a metal thin film. A preferred method is the wet plating method because of having a high film-forming rate. Any of an electroless plating method and an electrolytic plating method can be used for the wet plating method, but the electrolytic plating method is preferably used because of showing the high film-forming rate and forming a metallic film with high denseness.

A type of the metal for a plating layer is not particularly limited, but copper, nickel and gold are preferable, because of imparting high electroconductivity and high stability to the laminate. Among them, copper is more preferable, because of showing a lower ohmic value and being industrially available. The plating process includes the steps of: degreasing the surface to be plated and/or removing an oxide layer, as needed; and then immersing a base material in a plating solution. When having employed the electrolytic plating method, it is possible to form a plated layer by applying an electric current to the surface to be plated of the base material.

### Examples

Examples and comparative examples according to the present invention will now be described below. The present invention is not limited to the examples.
Measurement methods will be now described below which concern on a particle size of a particle of a precursor of a metal thin film, a volume resistivity of the metal thin film, adhesiveness/adhesive strength, the roughness of the interface between the metal thin film layer and an insulative resin layer, the maximum depth to which some of metal particles are embedded in the insulative resin layer, and an imidizing conversion ratio.

### (1) Size of particle of precursor of metal thin film

A particle size is determined by the steps of: dripping one droplet of a diluted dispersion containing dispersed particles on a copper mesh on which carbon is vapor-deposited; drying the droplet in a decompressed atmosphere to form a sample; observing the samples with a transmission-type electron microscope (JEM-4000 FX) made by Hitachi, Ltd.; selecting 3 points from a visual field, at which the samples show a comparatively similar particle size; taking photographs of the samples with the most suitable magnification for measuring the particle size to be measured; selecting three particles which are assumed to exist most generally from each photograph; measuring the diameter with a rule; and multiplying the particle diameter by the magnification to calculate the primary particle size; and calculating the average value of the values.

### (2) Volume resistivity of metal thin film

This volume resistivity of a metal thin film is measured by using "Loresta-GP (registered trademark)", made by Mitsubishi Chemical Corporation.

### (3) Tape peeling test and adhesive strength measurement (90-degrees peeling test)

The tape peeling test includes the steps of: affixing Scotch Tape (registered trademark of product made by Sumitomo 3M Limited) on the obtained metal thin film; peeing off the Scotch Tape; and determining the adhesive strength based on whether the metal thin film was peeled off from the base material while adhering to the Scotch Tape, or not.
A sample for measuring an adhesive strength is prepared by the steps of: electroplating a thick metallic film on the obtained metal thin film so that the total thickness of the metallic portion can be about 15 µm; and slitting the metallic film into a width of 10 mm and a length of 50 mm with a craft knife. A 90-degrees peeling test includes the steps of: slightly peeling one side of a slit with 10 mm width; affixing an aluminum tape onto the metallic film; fixing the tape to a peeling test machine; pulling the tape up in a 90-degree direction; measuring a necessary force for peeling the metallic film; and determining the force as the adhesive strength (kgf/cm).

### (4) Observation for metal thin film and morphology of interface between metal thin film and insulative resin layer

The morphology of the metal thin film is observed by using a TEM image of a cross section of the observed laminate with a transmission-type electron microscope (JEM-4000FX) made by Hitachi, Ltd. The roughness of the interface between the metal thin film layer and the insulative resin layer, and the maximum depth of some embedded metal particles in the insulative resin layer are observed by the steps of: digitizing the TEM image of the cross section of the formed interface by fusion-bonding of the metal thin film with a scanner to obtain a gray scale image of 8 bit; binarizing the image and extracting the edge to obtain an interface profile image (line image) of the metal thin film; estimating the roughness (Ra) of the interface between the metal thin film layer and the insulative resin layer by using a displacement amount from a straight line connecting both ends of the image profile image to the insulative resin layer side of the line image; and estimating a depth from the straight line connecting both ends of the image profile image to the deepest root as the maximum depth.

### (5) Imidizing conversion ratio

The case of forming a polyimide film by applying a polyamic acid will now be described. The imidizing conversion ratio due to heat treatment is determined by the steps of: heat-treating the polyamic acid; taking an infrared absorption spectrum of the surface; calculating a peak intensity (A1) of an imide group in the vicinity of 1780 cm⁻¹ and a peak intensity (B1) of a compound which does not change through an imidizing reaction in the vicinity of 1500 cm⁻¹ ; deriving a relative intensity of the imide group C1 = A1/B1 from the peak intensities; subsequently preparing a comparative sample by heat-treating the polyamic acid at 350°C for 4 hours to completely imidize the polyamic acid; measuring peak intensities (A0 and B0) in the vicinities of 1780 cm⁻¹ and 1500 cm⁻¹; deriving the relative intensity C0 = A0/B0; and calculating (100 × C1/C0) % by assuming the above relative intensity C0 as 100 and comparing the C0 with C1.

### [Example 1] Example of using thermoplastic polyimide for insulative resin layer

### (Preparation of microparticles of precursor of metal thin film, and of dispersion)

Microparticles of cuprous oxide having an average size of primary particles of 20 nm were obtained by the steps of: adding 70 ml of purified water to 8 g of anhydrous copper acetate (made by Wako Pure Chemical Industries, Ltd.); adding 2.6 ml of 64 wt% hydrazine hydrate so that the mole ratio of hydrazine to copper acetate was 1.2; and reacting the compounds with each other while stirring the solution at 25°C. The dispersion of cuprous oxide was obtained by the steps of: adding 2 g of polyethyleneglycol methyl ether (with number average molecular weight of 350 made by Aldrich) and 7 g of diethylene glycol to 3 g of the obtained cuprous oxide; and dispersing the cuprous oxide with an ultrasonic wave device.

### (Synthesis of thermoplastic polyimide solution)

A polyimide resin solution was prepared by the steps of: preparing a solvent-soluble polyimide resin by condensation-polymerizing 3,3',4,4'-diphenylsulphon tetracarboxylic dianhydride with aromatic diamine; preparing an NMP (N-methyl-2-pyrrolidone) solution (RIKACOAT PN-20 made by New Japan Chemical Co., Ltd.) containing 20 wt% by concentration of the solvent-soluble polyimide resin; and diluting the obtained solution into the 10 wt% solution by an addition of NMP. The thermoplastic polyimide showed the glass transition temperature of 270°C.

### (Preparation of substrate having thermoplastic polyimide layer)

A polyimide substrate (Kapton with film thickness of 50 µm made by DU PONT-TORAY CO., LTD) having a thermoplastic polyimide resin on the surface was prepared by the steps of: cutting out polyimide films having the same size; affixing the films on a glass substrate of a 10-cm square with a double-stick tape; setting the substrate on a spin coater (1H-D7 type) made by MIKASA Co., Ltd; pre-spinning the above described solution of the polyimide resin onto the polyimide film at 500 rpm for 5 seconds and then spin-coating the solution onto the polyimide film at 2,000 rpm for 10 seconds; and heating the spin-coated substrate on the hot plate at 90°C for 10 minutes, at 120°C for 10 minutes, at 150°C for 10 minutes, at 180°C for 10 minutes, at 250°C for 60 minutes and at 300°C for 60 minutes.

### (Preparation of metal thin film)

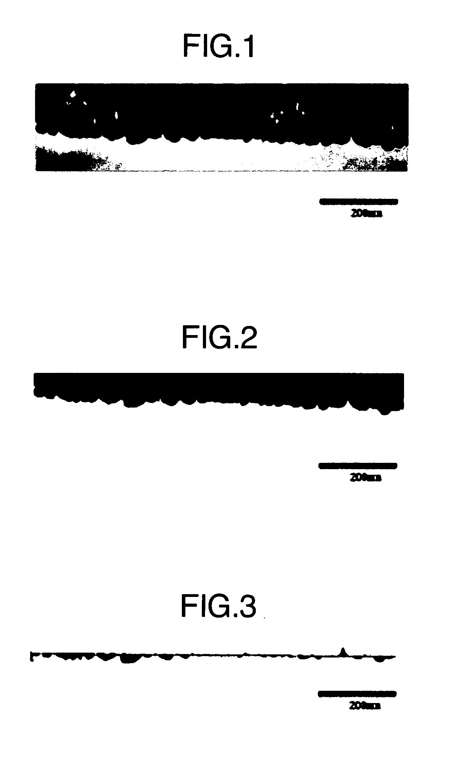

The above described polyimide substrate was set on the spin coater again, and the dispersion of the above described particle of cuprous oxide was applied on the substrate by dripping 2 mL of the dispersion and spin-coating the dispersion at 500 rpm for 15 seconds. Next, the coating film was baked at a higher temperature than the glass transition temperature of the above described polyimide film (270°C), on a hot plate at 350°C for 30 minutes in a condition of 200 ppm oxygen by concentration, while nitrogen gas was sent. Then, a thin film was obtained which had a structure in which copper microparticles with a particle size of 20 nm or less were fusion-bonded to each other to form a large copper grain. It was confirmed that an interface between the polyimide film and the copper thin film had a structure in which particles with a size of about 10 to 50 nm formed of the fusion-bonded copper microparticles were embedded in the polyimide film into depths of about 20 nm at the maximum. The Ra of the interface was 8 nm. Fig. 1 is a cross section of a TEM image in the vicinity of the interface. Fig. 2 is a profile image showing the roughness of an interface after having captured Fig. 1 with a scanner, and binarizing the captured data. Fig. 3 is an analysis image of Ra. The copper thin film showed a volume ohmic value of 6.5 × 10⁻⁶ Ωcm. The peeling of the copper thin film by a tape peeling test was not observed at all.

### (Formation of plating layer, measurement of adhesive strength and analysis of peeling interface)

An electrolysis plating bath was prepared by the steps of: dissolving 80 g of copper sulfate pentahydrate (Wako Pure Chemical Industries, Ltd.) and 180 g of sulfuric acid in 1 liter of purified water to form a solution; and adding a plating additive to the solution. A complete laminate substrate was prepared by the steps of: pickling and degreasing the surface of the copper film obtained in the previous step; immersing the substrate in the plating bath; and electrolytically plating the copper film with copper with a current density of 3 A/dm² at room temperature so that the total thickness of a metallic layer (copper thin film layer plus copper film formed by plating) could be 15 µm. The laminate substrate showed a very high adhesive strength of 1.7 kgf/cm by a 90-degrees peeling test. Interfaces were formed after the copper layer and a polyimide layer were peeled off, and the interface of copper was analyzed with an XPS technique. As a result, it was confirmed that cuprous oxide existed therein.

### (Characteristics of laminate substrate)

A comb type electrode with sizes of line/space = 30 µm/30 µm was formed on the above described laminate substrate by using a photolithographic technique. Then, the line in electric wiring was extremely straight. Thus, it was confirmed that the laminate substrate can allow highly fine wiring to be formed thereon. In addition, the breaking of a wire possibly caused by the pinhole was not observed in the electric wiring. The formed comb type electrode was subjected to a migration test on conditions of temperature 85°C, humidity 85%, and applied voltage 100 V. After 1,000 hours of the test, the electrode showed insulation properties kept at a 10¹⁰ Ω level between the electric wires, and did not show an observable degradation of the insulation properties originating in moisture absorption.
Next, another laminate substrate was prepared with a similar method by forming a plated film into a thickness of 8 µm on another substrate having the copper thin film formed thereon. The number of pinholes was estimated by the steps of: cutting out the substrate into 200 mm × 200 mm square; shining visible light on the polyimide surface of the cut out substrate; and catching the visible light which has passed through the substrate into a copper side by using a charge-coupled device camera having pixels of 25 µm each. As a result, the number of observed pinholes was as few as 10 or less.

### [Example 2] Example which forms insulative resin layer of non-thermoplastic polyimide from polyimide precursor

### (Preparation of substrate having polyimide resin layer containing polyimide resin precursor)

An NMP solution of a polyamic acid was obtained by the steps of: dissolving 18.6 g (0.10 mol) of 4,4'-diaminobiphenyl in 250 g of N-methylpyrrolidone (NMP); adding 32.1 g (0.10 mol) of a powder of 3,3',4,4'-benzophenone tetracarboxylic dianhydride in the above solution; and stirring the mixture at 5°C for 8 hours. Furthermore, 7 g of NMP was added to 10 g of the polyamic solution to dilute the solution into a concentration of 10 wt%.
A polyimide substrate having a polyimide film formed thereon was prepared by the steps of: cutting out polyimide films having the same size; affixing the films on a glass substrate of a 10-cm square (Kapton with film thickness of 50 µm made by DU PONT-TORAY CO., LTD)with a double-stick tape; setting the substrate on a spin coater (1H-D7 type) made by MIKASA Co., Ltd; dripping the above described diluted polyamic acid onto the polyimide film; pre-spinning the diluted polyamic acid at 500 rpm for 5 seconds; then spin-coating the diluted polyamic acid onto the polyimide film at 2,000 rpm for 10 seconds; and heating the spin-coated substrate on a hot plate at 120°C for 30 minutes and 200°C for 30 minutes. The polyimide film showed an imidizing conversion ratio (R1) of 90%.

### (Preparation of metal thin film)

The above described polyimide substrate was set on a spin coater again, and 2 mL of the same dispersion of the particle of cuprous oxide as in Example 1 was dripped on the substrate and spin-coated at 500 rpm for 15 seconds. Subsequently, the coating film was baked on a hot plate at 350°C for 1 hour in a condition of 150 ppm oxygen by concentration. Then, a thin film was obtained which had the structure in which copper microparticles with a particle size of 20 nm or less were fusion-bonded to each other to form a large copper grain.
In addition, as a result of having analyzed an imidizing conversion ratio R2 of the polyimide film, the ratio was 100%. The copper thin film showed a volume ohmic value of 5.1 × 10⁻⁶ Ωcm. The copper thin film was subjected to a tape peeling test, but did not show peeling at all.

### (Formation of plating layer, measurement of adhesive strength and analysis of peeled interface)

A laminate substrate with the copper film thickness of 15 µm was obtained by plating copper on a substrate provided with the copper thin film through the same operation as in Example 1. It was confirmed that the copper thin film had a structure in which copper microparticles were fusion-bonded to each other and an interface between the polyimide film and the copper thin film had a structure in which particles with a size of 10 to 40 nm formed of the fusion-bonded copper microparticles were embedded in the polyimide film into depths of about 15 nm at the maximum. The Ra of the interface was 7 nm. The laminate substrate showed a very high adhesive strength of 1.6 kgf/cm by a 90-degrees peeling test. Interfaces were formed after the copper layer and a polyimide layer were peeled off, and the interface of copper was analyzed with an XPS technique. As a result, it was confirmed that cuprous oxide existed therein.

### [Example 3] Example of using thermoplastic polyimide for insulative resin layer

A solution of polyamide acid which is a precursor of thermoplastic polyimide was prepared by the steps of: weighing out 2,2'-bis(4-(4-aminophenoxy)phenylpropane) and 3,3',4,4'-diphenylsulphon tetracarboxylic dianhydride so as to be a ratio of 1.0 mol: 1.0 mol; adding NMP so that the solid content can be 10 wt% by concentration; and dissolving the compounds in NMP while stirring the solution at 50°C for 10 hours. A polyimide substrate having a thermoplastic polyimide resin on the surface was prepared by the steps of: applying the polyamide acid solution onto the polyimide film; pre-spinning the solution at 500 rpm for 5 seconds; then spin-coating the solution onto the polyimide film at 2,000 rpm for 10 seconds; and heating the spin-coated substrate on a hot plate at 120°C for 30 minutes, 200°C for 10 minutes, 250°C for 60 minutes and 300°C for 60 minutes. The thermoplastic polyimide showed the glass transition temperature of 260°C.
The same dispersion of cuprous oxide as in Example 1 was spin-coated on the polyimide substrate, and then the substrate was baked on a hot plate at 350°C for 30 minutes in a condition of 200 ppm oxygen by concentration. A laminate substrate having a copper thin-film layer with the structure in which microparticles were fusion-bonded was obtained as in the case of Example 2. It was confirmed that the obtained copper thin film had a structure in which the copper microparticles were fusion-bonded to each other and an interface between the polyimide film and the copper thin film had a structure in which particles with a size of 10 to 50 nm formed of the fusion-bonded copper microparticles were embedded in the polyimide film into depths of about 25 nm at the maximum. The Ra of the interface was 15 nm. The obtained copper thin film showed a volume ohmic value of 5.5 × 10⁻⁶ Ωcm. The copper thin film was subjected to a tape peeling test, but did not show peeling at all. The laminate substrate was obtained by plating copper on the substrate having the copper thin film thereon as in the case of Example 1. As a result of subjecting the laminate substrate to a 90-degrees peeling test, the substrate showed an adhesive strength of 1.9 kgf/cm. Interfaces were formed after the copper layer and a polyimide layer were peeled off, and the interface of copper was analyzed with an XPS technique. As a result, it was confirmed that cuprous oxide existed therein.

### [Example 4] Dependency on baking condition

A laminate substrate having a plated layer was prepared in the same condition as in Example 3 except that the dispersion of cuprous oxide was baked at 350°C for 90 minutes in a heating condition of 40 ppm by concentration of oxygen. The copper thin film before the plated layer is formed thereon showed a volume ohmic value of 6.2 × 10⁻⁶ Ωcm. The laminate substrate showed an adhesive strength of 1.7 kgf/cm.
It was confirmed that the obtained copper thin film had a structure in which copper microparticles were fusion-bonded to each other and an interface between the polyimide film and the copper thin film had a structure in which particles with a size of 10 to 50 nm formed of the fusion-bonded copper microparticles were embedded in the polyimide film into depths of about 20 nm at the maximum. The Ra of the interface was 18 nm.
Interfaces were formed after the copper layer and a polyimide layer were peeled off, and the interface of copper was analyzed with an XPS technique. As a result, it was confirmed that cuprous oxide existed therein.

### [Example 5] Dependency on baking condition

A laminate substrate having a plated layer was prepared in the same condition as in Example 3 except that a dispersion of cuprous oxide was baked at 350°C for 10 minutes in a heating condition of 500 ppm oxygen by concentration. The copper thin film before the plated layer is formed thereon showed a volume ohmic value of 5.9 × 10⁻⁶ Ωcm. The laminate substrate showed an adhesive strength of 1.9 kgf/cm. It was confirmed that the obtained copper thin film had a structure in which copper microparticles were fusion-bonded to each other and an interface between the polyimide film and the copper thin film had a structure in which particles with a size of 10 to 50 nm formed of the fusion-bonded copper microparticles were embedded in the polyimide film into depths of about 20 nm at the maximum. The Ra of the interface was 10 nm. Interfaces were formed after the copper layer and a polyimide layer were peeled off, and the interface of copper was analyzed with an XPS technique. As a result, it was confirmed that cuprous oxide existed therein.

### [Example 6] Example of forming insulative resin layer of thermoplastic polyimide from polyimide precursor

A polyimide substrate was prepared by the steps of: applying a polyamide acid solution obtained in Example 3 onto the polyimide film; pre-spinning the solution at 500 rpm for 5 seconds; then spin-coating the solution onto the polyimide film at 2,000 rpm for 10 seconds; and heating the spin-coated substrate on a hot plate at 120°C for 30 minutes and 200°C for 30 minutes. The thermoplastic polyimide resin on the surface of the formed polyimide substrate showed an imidizing conversion ratio of 91%.
The same dispersion of cuprous oxide as in Example 1 was spin-coated on the polyimide substrate, and then the substrate was baked on a hot plate at 350°C for 30 minutes in a condition of 150 ppm oxygen by concentration. Thus obtained copper thin film showed a structure in which microparticles were fusion-bonded.
It was confirmed that the copper thin film had a structure in which copper microparticles were fusion-bonded to each other and an interface between the polyimide film and the copper thin film had a structure in which particles with a size of 10 to 50 nm formed of the fusion-bonded copper microparticles were embedded in the polyimide film into depths of about 15 nm at the maximum. The Ra of the interface was 8 nm. The baked thermoplastic polyimide resin layer showed an imidizing conversion ratio of 100%. The obtained copper thin film showed a volume ohmic value of 5.9 × 10⁻⁶ Ωcm. The copper thin film was subjected to a tape peeling test, but did not show peeling at all. The laminate substrate was obtained by plating copper on the substrate having the copper thin film thereon as in the case of Example 1. As a result of subjecting the laminate substrate to a 90-degrees peeling test, the substrate showed an adhesive strength of 1.8 kgf/cm.
Interfaces were formed after the copper layer and a polyimide layer were peeled off, and the interface of copper was analyzed with an XPS technique. As a result, it was confirmed that cuprous oxide existed therein.

### [Example 7] Example of forming thermoplastic polyamide-imide resin as insulative resin layer

A polyimide substrate having a thermoplastic polyamide-imide resin on the surface was prepared by the steps of: adjusting a polyamide-imide resin solution made by Toyobo Co., Ltd. so that the resin content becomes 10 wt% by diluting the solution with NMP; pre-spinning the solution on the polyimide film at 500 rpm for 5 seconds; then spin-coating the solution onto the polyimide film at 2,000 rpm for 10 seconds; and heating the spin-coated substrate on the hot plate at 120°C for 30 minutes and 300°C for 30 minutes to volatilize the solution.
The same dispersion of cuprous oxide as in Example 1 was spin-coated on the polyimide substrate, and then the substrate was baked on a hot plate at 350°C for 30 minutes in a condition of 200 ppm oxygen by concentration. Thus obtained copper thin film showed a structure in which microparticles were fusion-bonded.
It was confirmed that the copper thin film had a structure in which copper microparticles were fusion-bonded to each other and an interface between the polyimide film and the copper thin film had a structure in which particles with a size of 10 to 50 nm formed of the fusion-bonded copper microparticles were embedded in the polyimide film into depths of about 15 nm at the maximum. The Ra of the interface was 7 nm. The obtained copper thin film showed a volume ohmic value of 6.5 × 10⁻⁶ Ωcm. The copper thin film was subjected to a tape peeling test, but did not show peeling at all. The laminate substrate obtained by plating copper as in the case of Example 1 showed an adhesive strength of 1.3 kgf/cm by a 90-degrees peeling test.
Interfaces were formed after the copper layer and a polyimide layer were peeled off, and the interface of copper was analyzed with an XPS technique. As a result, it was confirmed that cuprous oxide existed therein.

### [Example 8] Example of coating dispersion to form pattern while using thermoplastic polyimide for insulative resin layer

### (Preparation of metallic wiring)

A polyimide substrate was obtained by the steps of: pre-spinning the polyamide acid solution obtained in Example 3 on a polyimide film at 500 rpm for 5 seconds; then spin-coating the solution onto the polyimide film at 2,000 rpm for 10 seconds; and heating the spin-coated substrate on a hot plate at 120°C for 30 minutes and 200°C for 30 minutes. The thermoplastic polyimide resin on the surface of the formed polyimide substrate showed an imidizing conversion ratio of 91%. The dispersion was coated into a circuit form by the steps of: making the polyimide substrate vacuum-absorbed on a table of a dispenser (made by Musashi Engineering, Inc.); fixing a syringe (FN-0.50N (inner diameter of 50 µm) made by Musashi engineering, Inc.) to a tip of a dispenser tube filled with the above described dispersion; connecting the syringe to an air supply tube of the dispenser; fixing the syringe in a predetermined position of a dispenser robot; applying an air pressure on the tube to extrude the dispersion; and moving the dispenser robot according to the wiring pattern programmed beforehand. In the above operation, a gap of the substrate and a leading edge of the syringe was adjusted to 90 µm.
Subsequently, the coated substrate was heat-treated on a hot plate at 350°C for 15 minutes in a condition of 100 ppm oxygen by concentration. Then, the polyimide resin layer showed an imidizing conversion ratio of 100%, and copper wiring with a line width of 130 µm was obtained. When a cross section of the wiring part was observed, the obtained copper wire showed the structure in which copper microparticles with a particle size of 20 nm or less were fusion-bonded to each other to form a large copper grain. It was confirmed that the copper wire had a structure in which copper microparticles were fusion-bonded to each other and an interface between the polyimide film and the copper wire had a structure in which particles with a size of 10 to 50 nm formed of the fusion-bonded copper microparticles were embedded in the polyimide film into depths of about 20 nm at the maximum. The Ra of the interface was 9 nm. The copper wire showed an ohmic value of 4 × 10⁻⁶ Ωcm when measured with a 4-terminal method. Cuprous oxide was confirmed to exist between the copper film and the thermoplastic polyimide resin layer. A solid film was separately formed. The film showed a high adhesive strength of 1.5 kgf/cm.

### [Example 9] Example in which dispersion containing particles of precursor of metal thin film includes metallic powder

A dispersion of cuprous oxide containing a metallic powder was obtained by the steps of: adding 3 g of a spherical copper powder with an average primary particle size of 0.3 µm, 2 g of polyethyleneglycol methyl ether (with number average molecular weight of 350 made by Aldrich) and 8 g of diethylene glycol to 6 g of the cuprous oxide with a particle size of 20 nm obtained in Example 1; and dispersing the cuprous oxide and the spherical copper powder in diethylene glycol with an ultrasonic wave device.
A laminate substrate was prepared by the steps of: spin-coating the above described dispersion of cuprous oxide on the substrate having the thermoplastic polyimide layer formed in Example 3; and baking the substrate on a hot plate at 350°C for 10 minutes in a condition of 500 ppm oxygen by concentration. The laminate substrate had a copper thin-film layer with the fusion-bonded structure. The obtained copper thin film had the structure in which the copper powder and the copper microparticles were fusion-bonded to each other. The roughness of a copper film interface was 30 nm by depth and 120 nm by Ra.
The obtained copper thin film showed a volume ohmic value of 6.1 × 10⁻⁶ Ωcm. The copper thin film was subjected to a tape peeling test, but did not show peeling at all. The laminate substrate was obtained by plating copper on a substrate having the copper thin film thereon as in the case of Example 1. As a result of subjecting the laminate substrate to a 90-degrees peeling test, the substrate showed an adhesive strength of 1.3 kgf/cm. Interfaces were formed after the copper layer and a polyimide layer were peeled off, and the interface of copper was analyzed with an XPS technique. As a result, it was confirmed that cuprous oxide existed therein.

### [Comparative example 1]

A copper thin film was formed on a polyimide substrate which has not a polyimide film formed thereon with the same method as in Example 1, but the formed copper thin film was completely peeled off in a tape peeling test.

### [Comparative example 2]

A copper thin film was formed on a polyimide substrate with the same operation as in Example 3 except that a dispersion of cuprous oxide was baked at 350°C for 10 minutes in a nitrogen atmosphere containing 3% hydrogen, and a plating film was further formed thereon. As a result of having measured an adhesive strength, the laminate showed the adhesive strength of 0.7 kgf/cm. Elements on the surface of the peeled copper thin film were analyzed, but copper oxide was not observed.

### [Comparative example 3]

A sample was prepared by applying a dispersion of cuprous oxide onto a substrate having a thermoplastic polyimide as an insulative resin layer, and heat-treating the substrate with the same method as in Example 1 except that the used cuprous oxide was prepared by pulverizing commercial cuprous oxide (made by Wako Pure Chemical Industries Ltd.) and had an average primary particle size of 1.2 µm. However, in the metal thin film layer, copper particles were not fusion-bonded to each other, and many cracks were formed on the surface of copper. Thus, the obtained copper thin film was incomplete.

### [Comparative example 4]

A copper film was formed on a polyimide substrate with the same operation as in Example 9 except that a dispersion of cuprous oxide was heated on a hot plate at 350°C for 10 minutes in a changed heating condition of using a nitrogen atmosphere containing 3% hydrogen, and a copper plating film was further formed thereon. As a result of having measured an adhesive strength, the laminate showed the adhesive strength of 0.5 kgf/cm. Elements on the surface of the peeled copper thin film were analyzed, but copper oxide was not observed.

### [Comparative example 5]

A laminate substrate was experimentally prepared by the steps of: forming a copper film with a thickness of 1 µm on a Kapton film with a thickness of 50 µm with a vapor deposition technique; and stacking a copper plating layer with a thickness of 8 µm thereon. The number of pinholes was estimated by the steps of: cutting out the substrate into 200 mm × 200 mm square; shining visible light on the polyimide surface of the cut out substrate; and catching the visible light which has passed through the substrate into a copper side by using a charge-coupled device camera having pixels of 25 µm each. As a result, the number of observed pinholes was as many as 300 or more.

### INDUSTRIAL APPLICABILITY

A laminate according to the present invention has a high electroconductivity nearly equal to a conventional metal thin film, and has extremely high adhesiveness between the metal thin film and the substrate. In addition, a process for producing the laminate can arbitrarily control a thickness of the metallic film and can easily form a metallic film of a thin film as well, so that the laminate can be particularly preferably used for a material of a flexible circuit substrate and the like. A laminate according to the present invention has an interface between an insulative resin layer and a metal layer, of which the roughness is extremely as low as about tens of nanometers, so that electric wiring with fine pitches and high wiring linearity can be formed on the laminate.
In addition, metallic wiring with high adhesiveness can be formed on an insulation substrate having an insulative resin layer and/or a precursor layer of the insulative resin formed thereon by directly drawing a wiring pattern by using a dispersion of microparticles of a precursor of a metal thin film with an ink jet method or the like, and heat-treating the substrate. Accordingly, the laminate can be used not only for forming a circuit of a printed wiring board, but also for manufacturing a bus electrode or an addressing electrode on a glass substrate in a process of manufacturing a flat panel display such as a plasma display panel and a liquid crystal panel.

## Claims

1. A laminate comprising:
an insulation substrate,
an insulative resin layer having an imide bond and/or an amide bond formed on the insulation substrate, and
a metal thin film layer which is formed on the insulative resin layer and contains a structure in which metal particles are fusion-bonded to each other, wherein
the metal thin film layer adheres to the insulative resin layer in such a state that some of the fusion-bonded metal particles are embedded in the insulative resin layer, and a metal oxide exists in a contacting interface between the metal thin film layer and the insulative resin layer.

2. The laminate according to claim 1, wherein the metal particle has a primary particle size of 200 nm or less.

3. The laminate according to any one of claims 1 and 2, wherein some of the metal particles are embedded in the insulative resin layer to a maximum depth of 100 nm or less at the contacting interface between the insulative resin layer and the metal thin film layer.

4. The laminate according to any one of claims 1 to 3, wherein the metal thin film layer has a surface roughness Ra in a range of 5 to 100 nm, in the contacting interface between the insulative resin layer and the metal thin film layer.

5. The laminate according to any one of claims 1 to 4, further comprising a metal-plated layer on the metal thin film layer.

6. The laminate according to any one of claims 1 to 5, wherein the insulative resin layer contains an insulative resin having a non-thermoplastic imide bond.

7. The laminate according to any one of claims 1 to 5, wherein the insulative resin layer contains an insulative resin having a thermoplastic imide bond.

8. The laminate according to claim 7, wherein the insulative resin layer contains a thermoplastic polyimide resin.

9. The laminate according to any one of claims 1 to 8, wherein the metal thin film layer contains copper, and the metal oxide existing in the contacting interface is cuprous oxide.

10. A process for producing the laminate according to any one of claims 1 to 4 comprising the steps of:
(1) forming an insulative resin layer having an imide bond and/or an amide bond, of which the modulus of elasticity changes by heat treatment, and/or a precursor layer of the insulative resin, on an insulation substrate; and
(2) applying a dispersion containing particles of a precursor of a metal thin film, which are fusion-bonded to each other by heat treatment, on the insulative resin layer and/or the precursor layer of the insulative resin, and heat-treating the dispersion in an atmosphere containing an oxidizing agent to form the metal thin film having a metal oxide in an interface between the metal film and the insulative resin layer.

11. A process for producing the laminate according to any one of claims 6 and 7 comprising the steps of:
(1) applying a solution of a precursor of a polyimide resin on an insulation substrate, and heat-treating the precursor to remove a solvent, subject the precursor to a dehydration condensation reaction and convert one part of the precursor into a polyimide resin; and
(2) applying a dispersion containing particles of a precursor of a metal thin film, which are fusion-bonded to each other by heat treatment, on a layer formed in the step (1), and heat-treating the dispersion in an atmosphere containing an oxidizing agent to convert the remaining precursor into a polyimide resin and simultaneously form a metal thin film having a metal oxide in the interface between the metal film and the polyimide resin.

12. The process according to claim 11, wherein a conversion to imide bond in step (1) is 70% or more but less than 100%.

13. A process for producing the laminate according to claim 8 comprising the steps of:
(1) applying a solution of a thermoplastic polyimide resin on an insulation substrate, and then removing a solvent to form a layer made from the thermoplastic polyimide resin on the insulation substrate; and
(2) then applying a dispersion containing particles of a precursor of a metal thin film, which are fusion-bonded to each other by heat treatment, on the layer made from the thermoplastic polyimide resin, and heat-treating the dispersion in an atmosphere containing an oxidizing agent to plasticize the thermoplastic polyimide resin and simultaneously form a metal thin film having a metal oxide in an interface between the metal thin film and the thermoplastic polyimide resin.

14. A process for producing the laminate according to claim 7 comprising the steps of:
(1) applying a solution of a thermoplastic polyamide-imide resin on an insulation substrate, and then removing a solvent to form a layer made from the thermoplastic polyamide-imide resin on an insulation substrate; and
(2) then applying a dispersion containing particles of a precursor of a metal thin film, which are fusion-bonded to each other by heat treatment, on the layer made from the thermoplastic polyamide-imide resin, and heat-treating the dispersion in an atmosphere containing an oxidizing agent to plasticize the thermoplastic polyamide-imide resin and simultaneously form the metal thin film having a metal oxide in an interface between the metal thin film and the thermoplastic polyamide-imide resin.

15. A process for producing the laminate according to claim 8 comprising the steps of:
(1) applying a solution of a precursor of a thermoplastic polyimide resin on an insulation substrate, and then heat-treating the solution to remove a solvent, subject the precursor to a dehydration condensation reaction, convert all the precursor into polyimide and form a layer made from the thermoplastic polyimide resin on the insulation substrate; and
(2) then applying a dispersion containing particles of a precursor of a metal thin film, which are fusion-bonded to each other by heat treatment, on the layer made from the thermoplastic polyimide resin, and heat-treating the dispersion in an atmosphere containing an oxidizing agent to plasticize the thermoplastic polyimide resin and simultaneously form the metal thin film having a metal oxide in the interface between a metal thin film and the thermoplastic polyimide resin.

16. The process according to any one of claims 13 to 15, wherein the heat treatment in step (2) is conducted at a temperature equal to or higher than a glass transition temperature of the thermoplastic polyimide resin or the thermoplastic polyamide-imide resin.

17. The process according to any one of claims 10 to 16, wherein the heat treatment is conducted in an inert gas atmosphere containing an oxidizing agent.

18. The process according to claim 17, wherein the oxidizing agent is oxygen and contained in a concentration of 30 to 500 ppm in the inert gas atmosphere.

19. The process according to any one of claims 10 to 18, wherein the particles of the precursor of the metal thin film are at least one selected from the group consisting of metal particles, metal oxide particles and metal hydroxide particles.

20. The process according to any one of claims 10 to 19, wherein the particles of the precursor of the metal thin film have a primary particle size of 200 nm or less.

21. The process according to any one of claims 19 and 20, wherein the particles of the precursor of the metal thin film are particles of cuprous oxide.

22. The process according to any one of claims 19 to 21, wherein the dispersion contains a polyalcohol.

23. The process according to any one of claims 19 to 22, wherein the dispersion contains a straight-chain aliphatic polyether compound.
